# EUROPEAN PATENT APPLICATION

(11) **EP 2 187 445 A1**
(43) Date of publication of application: **19.05.2010**
(21) Application number: 08169054.7
(22) Date of filing: 13.11.2008
(51) Int. Cl.: H01L 31/0352, H01L 51/42, H01L 31/18

(54) **Nanoparticle material**

(71) Applicant: Hitachi, Ltd., Chiyoda-ku Tokyo (JP)
(72) Inventor: Andreev, Aleksey, Cambridge, CB3 0HE (GB); Ando, Masahiko, Cambridge, CB3 0HE (GB); Williams, David, Cambridge, CB3 0HE (GB)
(74) Representative: Piotrowicz, Pawel Jan Andrzej

(57) **Abstract**

A material comprises an array of nanoparticles comprising a first semiconducting material and nanoparticles comprising a second, different semiconducting material. The nanoparticles form a heterostructure. The nanoparticles have dimensions and the materials yield band offsets such that the material exhibits a localised state which is higher in energy than a delocalised state.

## Description

The present invention relates to a nanoparticle material.

Photovoltaic or "solar" cells are often used as power sources in portable devices, such as desktop calculators, and in remotely-located systems, such as satellites. However, photovoltaic cells are set to play an increasingly important role in energy generation and are expected to replace power sources which rely on fossil fuels in some applications.

In a typical photovoltaic cell, photons generate excess charge carriers in a region formed by a p-n junction formed in bulk silicon. More recent photovoltaic cells use amorphous or thin-film silicon or are formed using other semiconducting materials, such as cadmium selenide.

An overview of photovoltaic cells can be found in Chapter 14 of "Physics of Semiconductor Devices", S. M. Sze, (2nd Edition, Wiley, 1981) and Chapter 8 of "Modern Semiconductor Device Physics" by M. A Green, ed. S. M. Sze, (Wiley, 1998).

In single junction photovoltaic cells, the maximum thermodynamic efficiency of converting a photon into electric free energy is about 31%. This is known as the Shockley-Queisser limit.

One process which significantly limits conversion efficiency of single junction photovoltaic cells is hot carrier relaxation. To generate an electron-hole pair (or "exciton"), the energy of an incoming photon must exceed the bandgap energy of the semiconducting material. However, much of this energy is wasted since the energy of the photon usually far exceeds the bandgap energy. Thus, absorption produces hot carriers which 'cool' by emitting phonons. This process can result in about 50% of the energy of the photon being wasted.

The conversion efficiency of a photovoltaic cell can be significantly increased by taking advantage of multiple exciton generation using quantum dots, as proposed in "Quantum dot solar cell", A. J. Nozik, Physica E, p 115 to 120, volume 13 (2002). By using quantum dots, impact ionisation can be enhanced leading to the production of two or more low-energy excitons for every photon.

In bulk material, impact ionisation requires conservation of both energy and momentum which restricts the number of available combinations of initial and final states of carriers participating in impact ionisation. Thus, the rate of impact ionisation is low. However, in a quantum dot, momentum need not be conserved and so the rate of impact ionisation is increased. Quantum confinement enhances the impact ionisation rate and also slows hot carrier relaxation.

Enhanced conversion efficiency has been observed in photoluminescence spectra in "PbTe colloidal nanocrystals: Synthesis, characterization, and multiple exciton generation", James E. Murphy, Matthew C. Beard, Andrew G. Norman, S. Phillip Ahrenkiel, Justin C. Johnson, Pingrong Yu, Olga 1. Mi 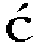 i 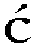 , Randy J. Ellingson and Arthur J. Nozik, Journal of the American Chemical Society, volume 128, pages 3241 to 3247 (2006).

Although quantum confinement can lead to increased efficiency in carrier generation, the very fact that a quantum dot is used means that the generated carriers are localised and so can be difficult to extract.

The present invention seeks to ameliorate this problem.

According to the present invention there is provided a material comprising an array of nanoparticles comprising a first semiconducting material and nanoparticles comprising a second, different semiconducting material, wherein said nanoparticles form a heterostructure and wherein the nanoparticles have dimensions and the materials yield band offsets such that the material exhibits a localised state which is higher in energy than a delocalised state.

Thus, the localised state can be used for multiple exciton generation, while the delocalised state can be used for carrier extraction and transport.

The material may be crystal or quasi-crystal. The array may be two- or three-dimensional and may have cubic symmetry.

The first semiconducting material may have a relatively large band gap and the second semiconducting material may have a relatively small band gap. The nanoparticles comprising the first semiconducting material may be relatively large and said nanoparticles comprising the second semiconducting material may be relatively small. A linear dimension, such as width or diameter, of said nanoparticles comprising the first semiconducting material may be between about 2 and 20 times, optionally between about 5 and 10 times, that of a corresponding linear dimension of said nanoparticles comprising the second semiconducting material. The nanoparticles may have a linear dimension which is at least 1 nm.

At least one of the semiconducting materials c may comprise a II-VI semiconductor, a III-V semiconductor or a IV semiconductor. At least one of the semiconducting materials may comprise an organic semiconductor.

The material may further comprise region(s) between the nanoparticles comprising an insulating material.

According to a second aspect of the present invention there is provided a device comprising a region comprising the material and at least two electrical contacts operatively connected to the region. Thus, the at least two electrical contacts can be used to excite the region and/or extract charge carriers from the region.

According to a third aspect of the present invention there is provided a device comprising a region comprising the material and a source of electromagnetic radiation configured to supply radiation to the region.

According to a fourth aspect of the present invention there is provided a photovoltaic cell comprising a carrier generation region comprising the material, a p-type semiconductor region and an n-type semiconductor region.

According to a fifth aspect of the present invention there is provided a method of forming a material, the method comprising forming an array of nanoparticles comprising a first semiconducting material and nanoparticles comprising a second, different semiconducting material, wherein said nanoparticles form a heterostructure.

Forming the array may include providing a substrate, providing a colloid of nanoparticles and allowing said nanoparticles to assemble on said substrate.

The method may comprise providing the nanoparticles comprising the first semiconducting material with a first type of linking means and providing the nanoparticles comprising the second semiconducting material with second type of linking means which complements the first type of linking means.

The first type of linking means may comprise a first type of deoxyribonucleic acid and the second type of linking means may comprise a second type of deoxyribonucleic acid.

Forming the array of nanoparticles may include depositing a layer of semiconducting material and patterning said layer of semiconducting material.

The method may comprise annealing the array of nanoparticles using electromagnetic radiation having a first wavelength.

The method may comprise annealing the array of nanoparticles using electromagnetic radiation having a second, different wavelength.

Embodiments of the present invention will now be described, by way of example, with reference to Figures 4 to 32 of the accompanying drawings in which:
Figure 1 illustrates a side view of a reduced-dimensional system;
Figure 2 is schematic diagram of density of states for the system shown in Figure 1;
Figure 3 illustrates multiple exciton generation in a reduced-dimensional system;
Figure 4 is a plan view of a material in accordance with the present invention;
Figure 5 is a cross-sectional view of the material shown in Figure 4 taken along the line A-A';
Figure 6 illustrates an interface between a core region and a bridge region shown in Figures 4 and 5;
Figure 7 is a schematic diagram of a band structure of a material comprising core and bridge regions in accordance with the present invention illustrating some localised states having a higher energy than a delocalised state;
Figure 8 is a schematic diagram of a band structure of a material comprising core and bridge regions before the core and bridge regions are coupled;
Figure 9 is schematic diagram of a density of states corresponding to the band structure shown in Figure 7;
Figure 10 illustrates part of a quantum dot crystal in accordance with the present invention;
Figure 11 is a schematic diagram of a band structure of the material shown in Figure 10 taken along the line B-B';
Figure 12 is a schematic diagram of a band structure of the material shown in Figure 10 taken along the line C-C';

Figure 13 is a schematic diagram of electronic band structure for the material shown in Figure 4;
Figure 14 is schematic diagram of electronic density of states corresponding to the electronic band structure shown in Figure 13;
Figure 15 illustrates a lattice constant for a quantum dot crystal in accordance with the present invention;
Figure 16 illustrates a Brillouin zone for a quantum dot crystal in accordance with the present invention;
Figure 17 illustrates a band structure for high-symmetry points of a cubic quantum dot crystal in accordance with the present invention;
Figure 18 is a schematic diagram of band structure for a quantum dot crystal in accordance with the present invention;
Figure 19 is a schematic diagram of photovoltaic cell including a region of a quantum dot crystal in accordance with the present invention;
Figure 20 illustrates photon absorption in the photovoltaic cell shown in Figure 19;
Figure 21 illustrates multiple exciton generation in the photovoltaic cell shown in Figure 19;
Figure 22 shows energy and momentum conservation during impact ionization in the photovoltaic cell shown in Figure 19;
Figure 23 illustrates extraction of charge carriers in the photovoltaic cell shown in Figure 19;
Figure 24 illustrates a computed band structure of a quantum dot crystal in accordance with the present invention;
Figure 25 illustrates the effect of changing band offset in a computed band structure of a quantum dot crystal in accordance with the present invention;
Figure 26 illustrates a quantum dot crystal formed using organic material;
Figure 27 is a process flow diagram illustrating a method of designing a quantum dot crystal in accordance with the present invention;
Figure 28 is a process flow diagram illustrating a first method of fabricating a quantum dot crystal in accordance with the present invention;
Figure 29 illustrates a quantum dot crystal at different stages during fabrication, made using the first process;
Figure 30 is a schematic diagram showing the effect of an annealing process;
Figure 31 is a process flow diagram illustrating a second method of fabricating quantum dot crystal in accordance with the present invention; and
Figure 32 illustrates a quantum dot crystal at different stages during fabrication made using a third process.

Before describing some embodiments of the present invention, an example of reduced-dimensional system will be described which may be useful for understanding the present invention.

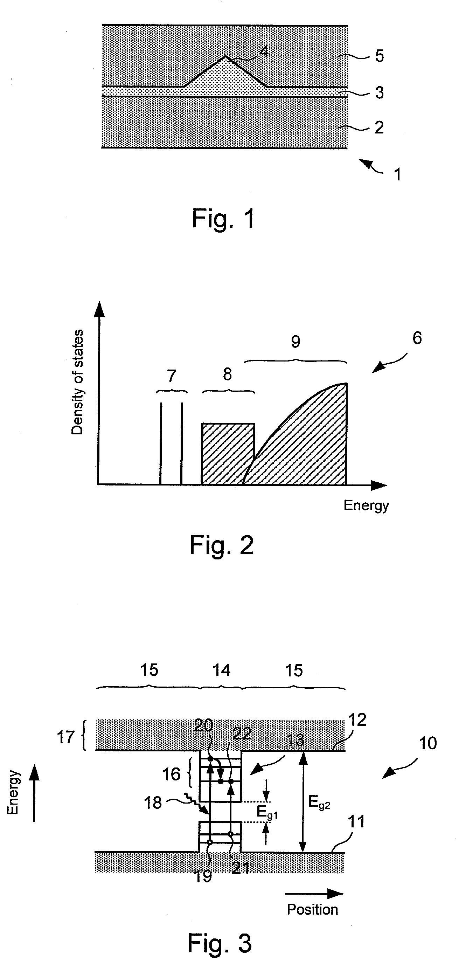

Referring to Figure 1, a reduced-dimensional system 1 is shown which includes a gallium arsenide substrate 2, a thin indium arsenide layer 3 (or "wetting layer"), an indium arsenide island 4, e.g. formed by Stranski-Krastanow growth, and a gallium arsenide coating layer 5. Typically the wetting layer is one monolayer thick and the indium arsenide island 4 is about ten monolayers thick.

Referring also to Figure 2, a plot 6 of electronic density of states for the reduced-dimensional system 1 is shown. The plot 6 includes isolated δ-function-like peaks 7 corresponding to zero-dimensional states, i.e. localised states, of a quantum dot formed by the indium arsenide island 4, a first continuous band 8 corresponding to two-dimensional states, i.e. a first set of delocalised states, formed by the wetting layer 3 and a second continuous band 9 corresponding to three-dimensional states, i.e. a second set of delocalised states, of a gallium arsenide matrix formed by the gallium arsenide substrate 2 and coating layer 5.

As shown in Figure 2, the reduced-dimensional system 1 exhibits an electronic density of states in which localised states are found at a lower energy than the delocalised states. This characteristic is typical of existing reduced-dimensional systems which include quantum dots.

This characteristic generally prevents quantum dots from being used to their full potential in photovoltaic cells because, even though localised states can be used to generate multiple charge carriers, the very fact that these states are localised means that carriers cannot be easily extracted, as will now be explained:

Referring to Figure 3, a band structure 10 of a reduced-dimensional system for generating charge carriers is shown.

The band structure 10 includes a valence band edge 11 and conduction band edge 12. A quantum dot 13 is formed by a semiconducting material 14 having a band gap E_{g1} embedded in a semiconducting material 15 with a larger bandgap E_{g2}. Discrete, localised states 16 are formed in the quantum dot 13 and continuous, non-localised states 17 appear at higher energy.

This type of system can exhibit multiple exciton generation whereby a photon 18 having an energy hV ≥ 2.E_{g1} (where h is Plank's constant, V is frequency and E_{g1} is the band gap energy of the semiconducting material 14) generates a high-energy electron-hole pair 19, 20, i.e. an exciton. Excess energy of the electron 19 is sufficient to generate a second electron-hole pair 21, 22. This process is known as impact ionization or the reverse Auger effect.

As shown in Figure 3, the electrons 20, 22 occupy discrete states 16 and so are not mobile. Thus, even though the quantum dot 13 can help generate additional charge carriers which could lead to an increased photocurrent, the fact that the carriers are confined to the well means that they cannot be easily extracted.

A solution to this problem is to provide a system or material in which at least one localised state appears at a higher energy than a delocalised state. Thus, the localised state can be used to generate multiple pairs of charge carriers from a single photon, while the delocalised state can be used to extract charge carriers.

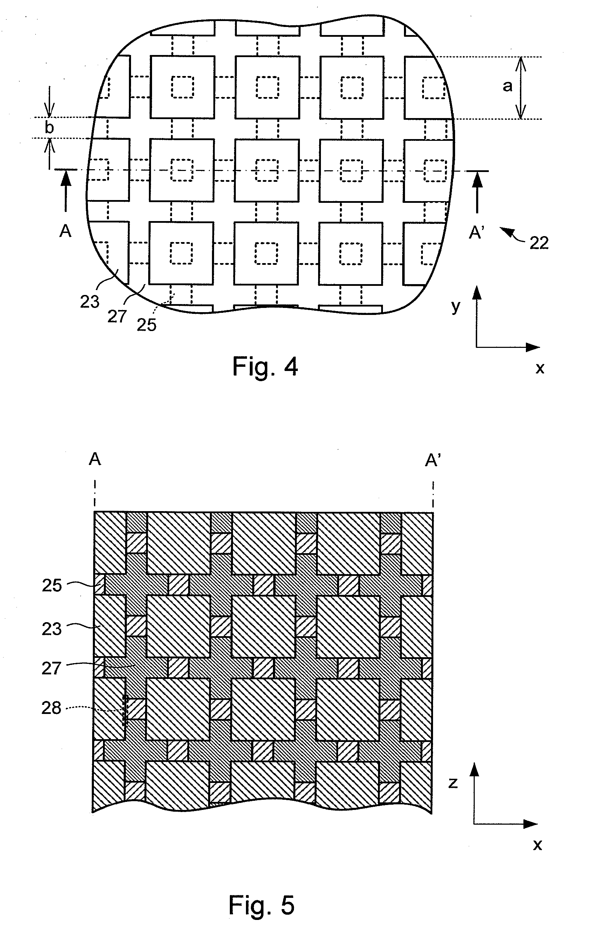

Referring to Figures 4 and 5, a material 22 (herein also referred to as a "nanoparticle crystal" or "quantum dot crystal") is shown.

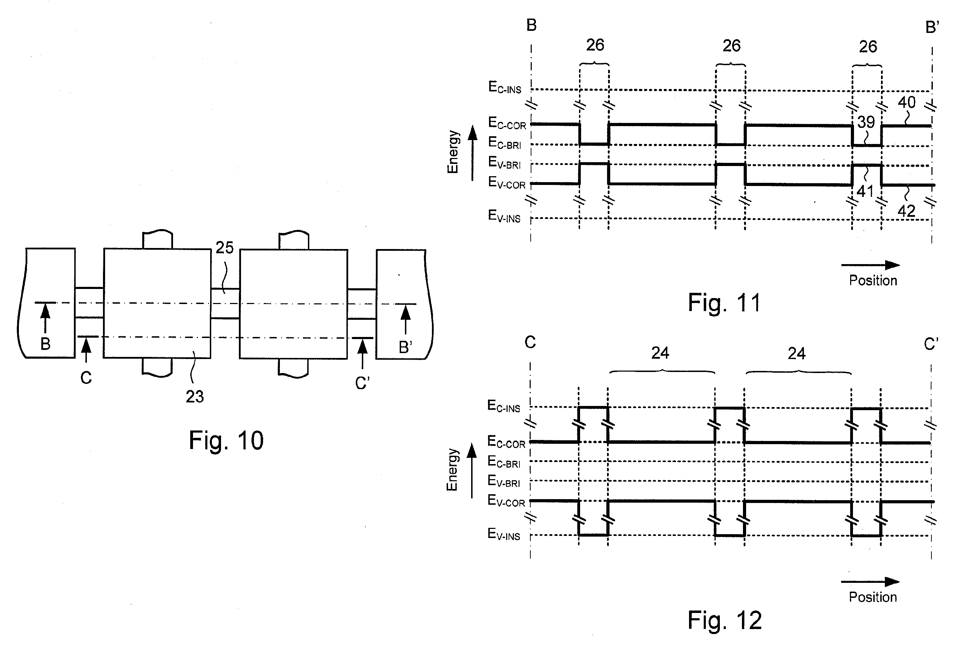

The material 22 includes a periodic or quasi-periodic array of nanometre-sized regions 23 (herein referred to as "core regions") of a first semiconducting material which provide an array of quantum dots 24 (Figure 12) of a first type (herein referred to as "core quantum dots"). The material 22 also includes nanometre-sized regions 25 (herein referred to as "bridge regions") of second, different semiconducting material which provides quantum dots 26 (Figure 11) of a second type (herein referred to as a "bridge quantum dot") and which connect together the core regions 23. The region 27 (or regions) between the core and bridge regions 23 may comprise an insulating material thereby forming a matrix or be left void.

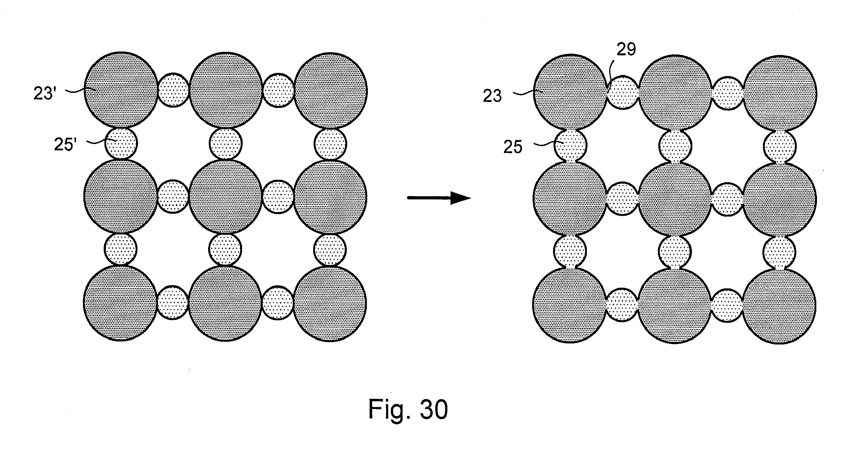

In Figures 4 and 5, the core and bridge regions 23, 25 are schematically shown as cubes for clarity and for the purposes of computer modelling. However, the core and bridge regions 23, 25 are (physically) generally spherical as shown in Figure 30. The core and bridge regions can be generally polyhedrons (which may be regular or irregular and which may be a Platonic or Archimedean solid), generally spherical, generally ellipsoid or generally irregularly-shaped. The core and bridge regions need not be the same shape. For example, the core region can be generally cubic and the bridge regions can be generally spherical.

The core and bridge regions are herein also referred to as "nanoparticles" or "nanocrystals".

One or both of the first and second semiconducting materials may be a IV-VI semiconductor. For example, one semiconducting material may be PbSe (E_{g} = 0.28 eV) and the other semiconducting material may be PbEuSe (E_{g} = 0.44 eV). The IV-VI material(s) need not be based on PbSe, but may be based on PbS (E_{g} = 0.42 eV) or PbTe (E_{g} = 0.31 eV). The substitutional element need not be Eu, but can be other rare-earth elements, such as Sr. One or both of the first and second semiconducting materials may be a III-V semiconductor. For example, one semiconducting material may be InAs and the other semiconducting material may be GaAs or AlGaAs. One or both of the first and second semiconducting materials may be a II-VI semiconductor. For example, one semiconducting material may be CdS, Cd Se or CdTe. One or both of the first and second semiconducting materials may be a IV-IV semiconductor or a group IV semiconductor. The semiconducting materials may be a binary semiconducting material, a tertiary semiconducting material or quaternary (or the like). One or both of the semiconducting materials may be an organic semiconducting material.

The core regions 23 have a dimension (e.g. width or diameter), a, and the bridge regions 25 have a corresponding dimension, b. The separation of discrete energy levels in the core and bridge quantum dots 24 (Figure 12), 26 (Figure 11) are determined by a size-limiting dimension. For example, if the core and bridge regions are generally spherical, then the diameter is the size-limiting dimension. However, for ease of computer modelling, the spherical core and bridge regions may be assumed to be cubes have a width equal to the diameter.

The core and bridge regions 23, 25 are sufficiently small to exhibit zero dimensional states at an operating temperature, T. Preferably, the operating temperature, T, is room temperature, i.e. about 290 °K. Thus, the core and bridge regions 23, 25 may have a diameter of the order of 1 nm or 10 nm. The ratio of the dimensions the core region 23 to the bridge region 25 (i.e. a:b) is about 5: 1. However, the ratio may be between about 20:1 to about 2:1.

The quantum dot crystal 22 has cubic symmetry. However, the crystal 22 need not have symmetry in all directions or may have symmetry but with different values of lattice constants in different directions. Thus, the crystal 22 may exhibit direction-dependent behaviour.

The quantum dot crystal 22 may be a one-dimensional crystal, a two-dimensional crystal, or a three-dimensional crystal. The number of core regions 23 in an array along a direction (e.g. along the x-, y- or z-direction) can be about 5 to 10 or of the order of 10¹ (i.e. between 10 and 99), 10² or more, e.g. exceeding 10⁶.

The core and bridge regions 23, 25 form a unitary structure, a heterostructure, for electronic transport. Heterojunctions 28 are formed at interfaces between core and bridge regions 23, 25. Thus, some states can extend freely through core and bridge quantum dots 24 (Figure 12), 26 (Figure 11) via bridge coupling, similar to that described in EP-A-1 860 600, and form non-localised states through the structure.

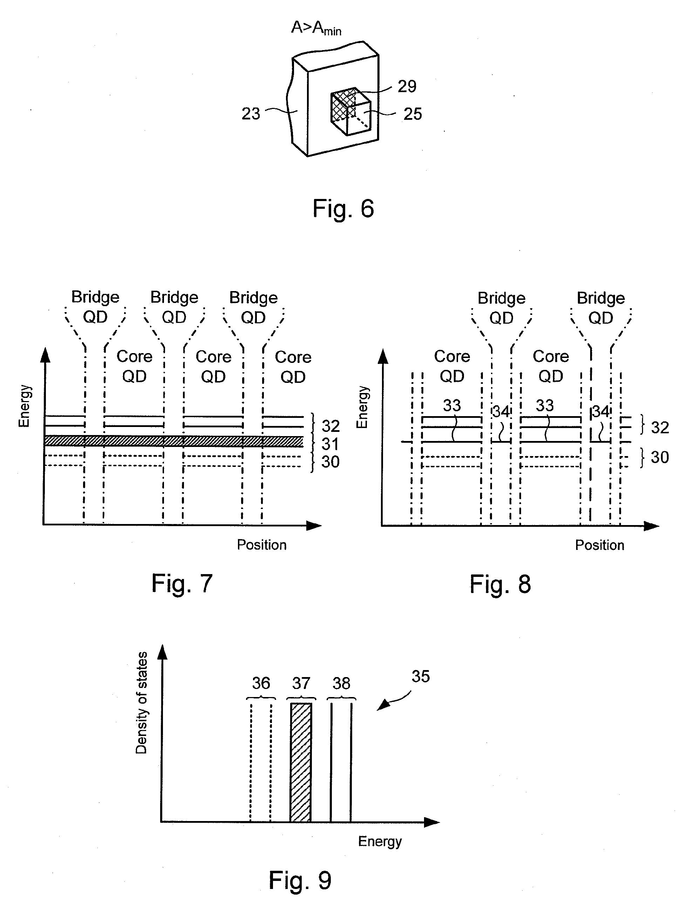

As shown in Figure 6, the core and bridge regions 23, 25 form a contact 29 over an area, A, which is greater than a minimum area, Aₘᵢₙ. The area is greater than the area of contact between two touching spheres. The minimum area, Aₘᵢₙ, may be about 3 nm² or 10 nm². As will be explained in more detail later, the core and bridge regions 23, 25 may form a fused contact using an annealing process.

Figure 7 is a schematic diagram of the energy states of a quantum dot crystal in accordance with the present invention which includes core and bridge regions which provide core and bridge quantum dots respectively. The quantum dot crystal may include one or more localised states 30 in core quantum dots having energies which are lower than a delocalised state 31 which extend through the core quantum dots and bridge quantum dots. However, the quantum dot crystal includes one or more localised states 32 which appear above the delocalised state 31. A quantum dot crystal may have several delocalised states and, as will be explained in more detail later, the quantum dot crystal can have a ground state which is delocalised.

Formation of the delocalised state(s) 31 can be understood by considering a situation in which core and bridge quantum dots are isolated and decoupled.

Referring also to Figure 8, isolated core quantum dots include another localised state 33 and isolated bridge quantum dots include a localised state 34 having the same energy. By coupling the previously-isolated core and bridge quantum dots, the states 33, 34 having the same energy come into resonance and form the band 32 shown in Figure 7.

Referring also to Figure 9, a schematic diagram of electronic density of states 35 for the quantum dot material is shown. The electronic density of states 35 may include a set of isolated δ-function-like peaks 36 corresponding to the zero-dimensional states 30 of the core quantum dots. The electronic density of states 35 includes a quasi-continuum band 37 corresponding to the freely-extended state 31 and a set of isolated δ-function-like peaks 38 corresponding to the zero-dimensional states 32 of the core quantum dots which appear above the continuous band 37. This characteristic can be used in many applications, such as in photovoltaic cells.

The number of localised states 30, 32, the number of delocalised bands 31 and the position (in energy) of the localised state(s) 30, 32 relative to the delocalised state(s) 31 can be controlled by choice of materials and the sizes of the core and bridge regions. For example, the materials and sizes may be chosen to produce a ladder of alternating localised and delocalised states. Additionally or alternatively, the materials and sizes may be chosen so that the ground state of the material is delocalised.

The material 22 shown in Figure 4 and 5 exhibits a delocalised ground state and localised excited states can be put to use in a photovoltaic cell, as will now be described.

Referring to Figures 10, 11 and 12, the materials forming the core region 23 and the bridge region 25 are chosen so as to provide suitable band alignments (i.e. band offsets) and band gaps such that a conduction band edge 39 of the bridge region 25 is lower than the conduction band edge 40 of the core region 23 and that a valence band edge 41 of the bridge region 25 is higher than the valence band edge 42 of the core region 23 so as to lead to formation of bridge quantum dots 25. The material forming the insulating region is chosen to provide a large potential barrier to both the core and bridge regions 23, 25. By leaving the region void or by using a suitable insulating material, the offsets lead to the core regions 23 forming core quantum dots 24.

The core region 23 is coextensive with the core quantum dot 24 and so the core region 23 can be referred to as the core quantum dot 24 and *vice versa.* However, the core quantum dot 24 may be smaller than the core region 23, e.g. due to surface states, which leads to formation of a depletion region. Likewise, the bridge region 26 is coextensive with the bridge quantum dot 25 and so the bridge region 26 can be referred to as the bridge quantum dot 25 and *vice versa.*

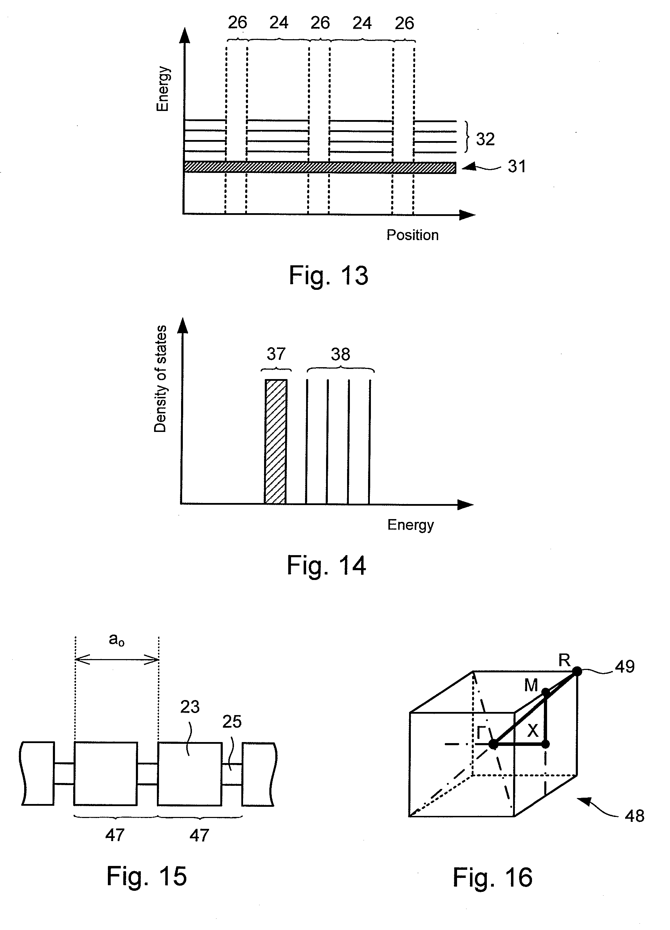

As shown in Figure 13, a ground (electron) state 31 is formed which is delocalised and some of the excited states 32 are localised.

As shown in Figure 14, this property is represented in the density of states of the system by a band 37 which corresponds to the electron ground state 31 and well-defined, isolated peaks 38 at higher energy corresponding to the localised excited states 32 similar to that described earlier.

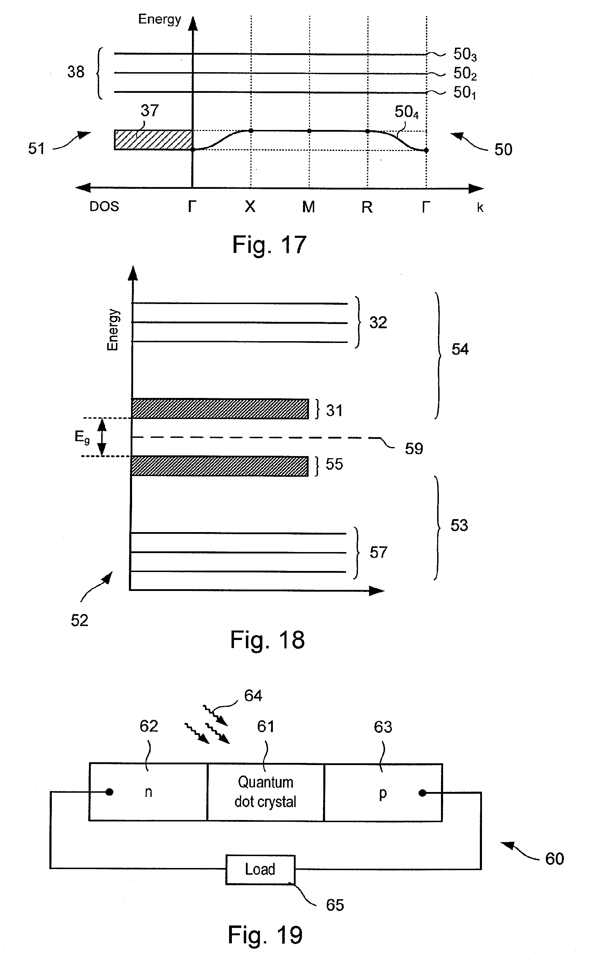

Thus, the delocalised ground electron state 31 and, similarly, a corresponding delocalised ground hole state 55 (Figure 18) can be used to conduct current, whereas one or more of the localised excited electron states 32 and corresponding localised excited hole states 57 (Figure 18) can be used for enhanced photon absorption, multiple-exciton generation and reduced carrier relaxation.

Referring again to Figures 4 and 5, the quantum dot crystal 22 is a periodic structure having simple cubic lattice symmetry. However, other symmetries can be used and more complicated geometries can be used.

Referring to Figures 15 and 16, the quantum dot crystal 22 is periodic having a lattice constant, aₒ, between neighbouring cells 47. Thus, a Brillouin zone 48 in three-dimensional quasi-momentum space can be defined having high symmetry points 49, namely F, X, M and R.

Referring to Figure 17, a schematic diagram of a set of dispersion curves 50, i.e. plots of energy in k-space, along high symmetry points F, X, M and R for the quantum dot crystal 22 is shown. A plot 51 of the corresponding density of states is also shown. As shown in Figure 17, flat dispersion curves 50₁, 50₂, 50₃ corresponding to the localised states 32 (Figure 13), while an energy band 50₄ corresponds to the delocalised state 31 (Figure 13).

Referring to Figure 18, a schematic band structure 52 for the quantum dot crystal 22 is shown which includes valance and conduction bands 53, 54. As shown in Figure 18, the ground states for electrons and holes are delocalised, thereby forming bands 31, 55. Excited states are localised, thereby forming discrete levels 32, 57. A Fermi level 59 of the non-excited quantum dot crystal in equilibrium appears in the band gap.

This characteristic can be used in a photovoltaic cell to increase efficiency and an example of a photovoltaic cell or "solar cell" will now be described.

Referring to Figure 19, a schematic diagram of a solar cell 60 is shown. The solar cell 60 includes a region 61 of the quantum dot crystal 22 described earlier sandwiched between an n-type semiconductor region 62 and p-type semiconductor region 63, e.g. comprising the same material as the core region. In operation, the solar cell 60 is exposed to light, i.e. photons 64, and a load 65 is connected across the cell 60. The quantum dot crystal 22 may be a two-dimensional crystal or a three-dimensional, i.e. multilayer structure.

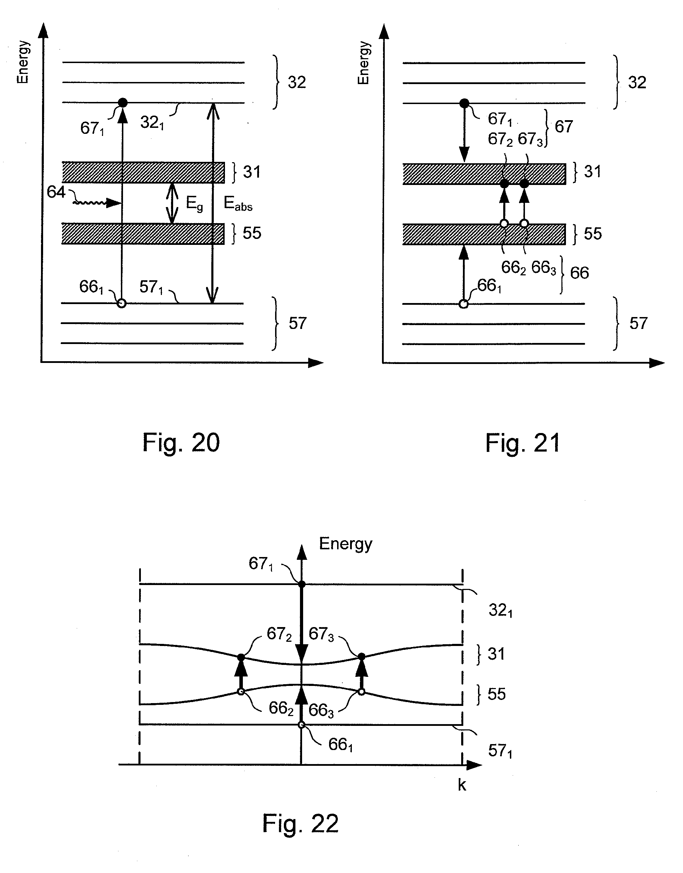

Referring to Figures 20 and 21, a photon 64 having an energy hν > E_{g} is absorbed which generates a high-energy electron-hole pair 66₁, 67₁, i.e. an exciton, via first excited states 32₁, 57₁. As shown in Figure 21, further electron-hole pairs 66₂, 67₂, 66₃, 67₃ are generated via impact ionisation, thus leading to multiple excitons 66, 67 being generated per single photon 64.

As shown in Figure 22, impact ionisation is effective because initial, excited states 32₁, 57₁ are localised (or quasi-localised) thus providing strong confinement-enhanced Coulomb scattering. Moreover, quasi-momentum and energy conservation can be easily satisfied due to band-like dispersion of the ground states 31, 57.

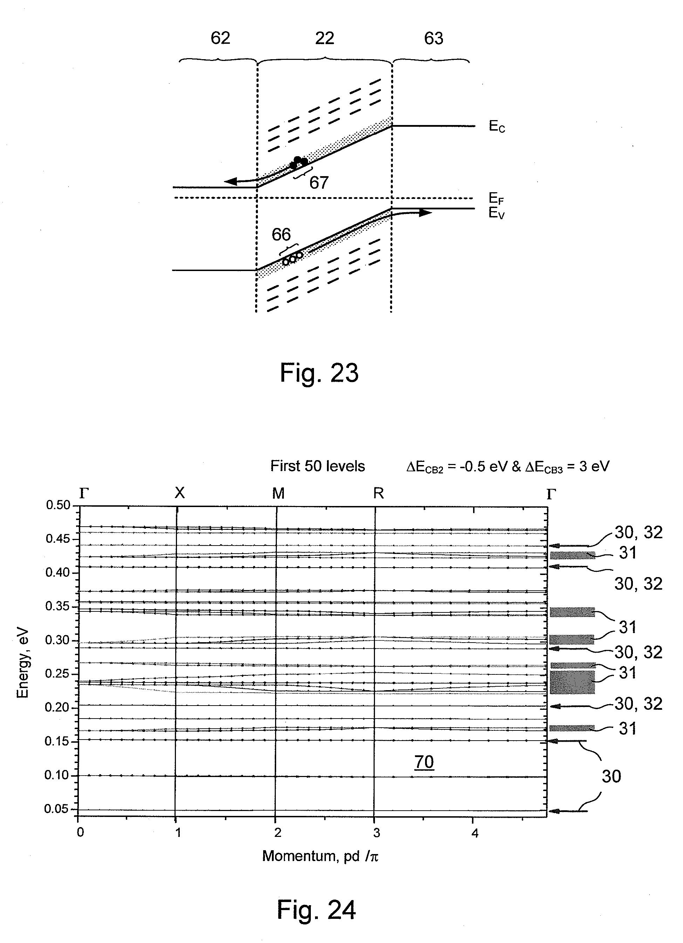

Referring to Figure 23, electrons and holes 66, 67 are separated by moving towards the n-type and p-type regions 62, 63 respectively, i.e. operating in a similar way to a single p-n junction solar cell. However, unlike a conventional p-n junction solar cell, the solar cell 60 can exceed Shockley-Queisser efficiency limit (of around 32%) due to multiple-exciton generation.

Referring to Figure 24, a calculated band structure 70 for a quantum dot crystal is shown. The band structure 70 is calculated using a plane-wave expansion method to solve the Schrödinger equation in three dimensions.

Lines of energy against quasi-momentum are plotted along the high-symmetry lines Γ, X, M, R, Γ for a simple cubic lattice Brillion zone. Parameters for a III-V semiconductor system, namely InAsSb, are used. The effective mass for each of the materials forming the core, bridge and insulating regions is set to 0.05 m₀ (where m₀ is the free electron mass). The conduction band offsets for the core-bridge interface and the core-matrix interface are ΔE_{CB2} = -0.5 eV and ΔE_{CB3} = 3 eV respectively. The core quantum dot size is 20×20×20 nm³ and the bridge quantum dot size is 4×4×4 nm³.

Localised states showing a flat dispersion are marked by arrows 30, 32 and delocalised states are marked by shaded rectangles 31.

As explained earlier, it is possible to control which states 30, 31, 32 are localised and which ones are delocalised by changing the band offset between the materials forming the core and bridge regions 23, 25 (Figures 4 & 5), by choosing and fixing the core material and varying the bridge material.

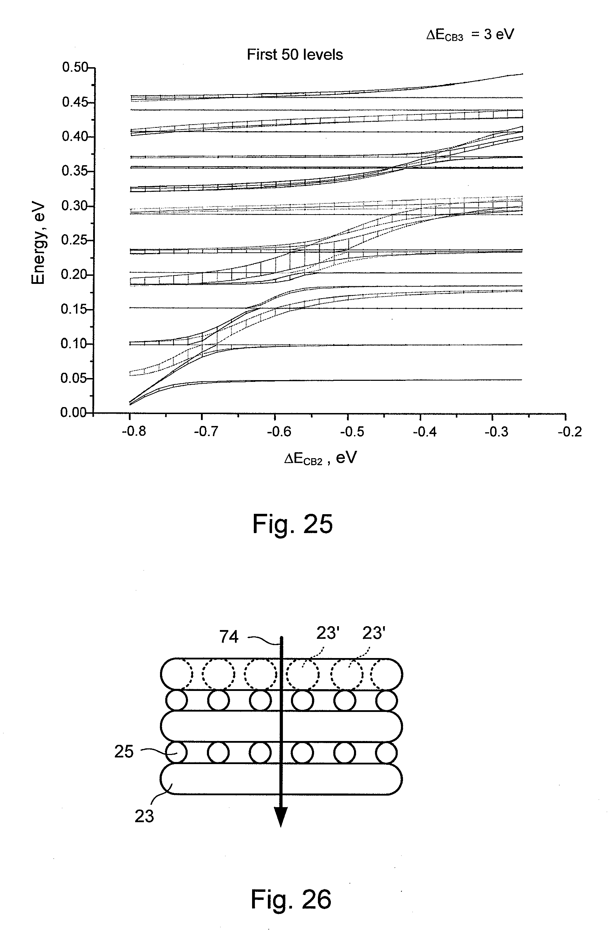

Referring to Figure 25, if the core-bridge band offset, ΔE_{CB2}, is changed, then a clear anti-crossing dependence of the energy levels can be seen. Increasing the band offset allows states near the ground state to become delocalised, which can be used, for example, in solar cell applications.

It will be appreciated that quantum dot crystals having other, different band structures can be formed and/or used in other applications, such as in memory, control, energy storage and quantum information processing. Moreover, the quantum dot crystal described herein can be used in applications other than solar cells.

The quantum dot crystal can be formed from inorganic materials and/or from organic materials. For example, the quantum dot crystal can be formed as a hybrid of organic and inorganic materials, as shown in Figure 26.

In Figure 26, a quantum dot crystal may be formed from organic, even biological, molecules or clusters to form core regions 23. Each core region 23 can behave as a single, extended core region 23 or provide an array of separate core regions 23'. Inorganic or organic material can be used to form bridge regions 25. The use of chains or extended regions can lead to the quantum dot crystal 22 having increased mobility in a given direction 74.

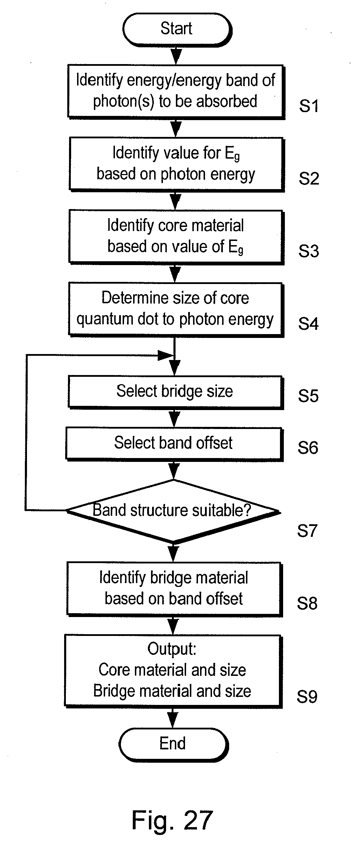

Referring to Figure 27, a method of designing a material for solar cell is shown.

The energy hν or energy band of photons to be absorbed is identified (step S1). The energy hV is used to determine a value (or range of values) for band gap energy, E_{g}, for example, using hν ≥ n.E_{g} where n ≥ 2 (step S2). The value of n can be chosen based on the number of multiple excitons required.

Using a value (or range of values) for band gap energy, E_{g}, a suitable semiconductor material for the core region 23 (Figures 4 & 5) can be identified (step S3). Once a material has been identified, an effective mass is known and so a value (or range of values) for the width or diameter of the core region 23 (Figures 4 & 5) can be determined so as to provide a suitable set of quantised energy levels (step S4).

A search is made for suitable bridge material and a suitable size of bridge region 25 (Figures 4 & 5) (steps S5 to S8).

An initial size of the bridge region 25 (Figure 5) is selected (step S5) based on a lower limit of a range. For example, the size can be calculated based on the ratio of size of the core region to the size of the bridge region and so an initial size can be found using a ratio of about 2:1 (wide search) or about 5:1 (narrow search).

Band structures for different band offsets can be calculated (step S6) to produce plots similar to those shown in Figure 25. The plot can be inspected to determine whether a suitable band structure exists (step S7).

If no band offset yields a suitable band structure, then a new size of bridge region 25 (Figures 4 & 5) is selected (step S5), e.g. by increasing the size in, e.g. 1 nm or 0.1 nm steps, and repeating steps S6 and S7. The process can be repeated up to an upper limit of a range, e.g. found using a ratio of about 20:1 (wide search) or about 10:1 (narrow search).

Once a suitable band structure has been identified, the band offset is used to find a band gap energy which in turn is used to identify a material (step S8). For example, if the core material is binary alloy, then this may involve adding a further component to the binary alloy to make a tertiary alloy. If the core material is already a tertiary alloy, then identifying a material may involve varying the composition the tertiary alloy until the required band gap is found.

The identities of the core and bridge material, together with their respective sizes can be output (step S9) and used to fabricate the quantum dot crystal.

The method shown in Figure 27 can be applied to designing materials for other applications.

The quantum dot crystal can be fabricated by self-assembly, using lithographic techniques in conjunction with epitaxial growth and etching or other techniques.

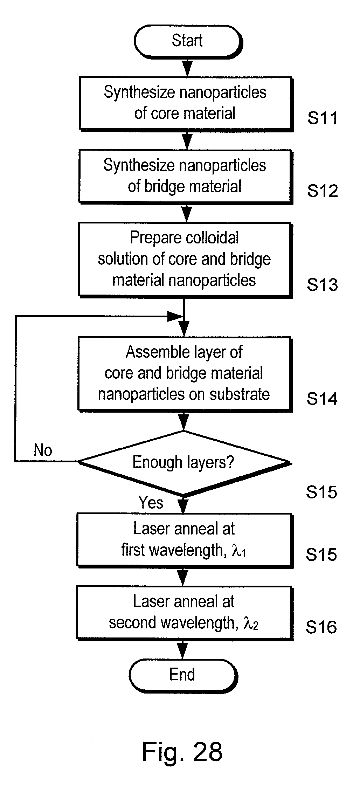

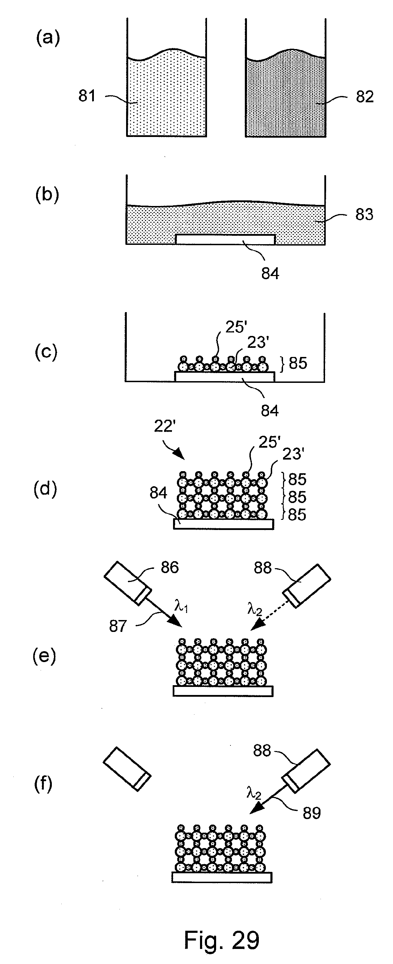

Referring to Figures 28 and 29a to 29f, a first method of fabricating a quantum dot crystal will now be described.

Layers of nanoparticles are assembled in a substrate using techniques similar to those described in "Structural diversity in binary nanoparticle superlattices", Elena V. Shevchenko, Dmitri V. Talapin, Nicholas A. Kotov, Stephen O'Brien and Christopher B. Murray, Nature, volume 439, pages 55 to 59 (2006) and "Synergism in binary nanocrystal superlattices leads to enhanced p-type conductivity in self-assembled PbTe/Ag2Te thin films", J. J. Urban, D. V. Talapin, E. V. Shevchenko, C. R. Kagan, and C. B. Murray, Nature Materials, volume 6, page 115 to 121 (2007)." describe self-assembled binary nanoparticle superlattice structures based on PbSe. Further reference is also made to "Preparation and Characterization of Monodisperse PbSe Semiconducting Nanocrystals in a Noncoordinating Solvent", William W. Yu, Joshua C. Falkner, Bertam S. Shih and Vicki L. Colvin, Chemical Materials, volume 16, pages 3318 to 3322 (2004).

Nanoparticles of core and bridge material having the desired sizes are synthesised and colloidal solutions 81, 82 containing core and bridge materials are prepared (steps S11 and S12). The colloidal solutions 81, 82 are mixed to form a mixed colloidal solution 83 (step S13).

A substrate 84 is placed into the colloidal solution 83 as shown in Figure 29b and the solution 83 is allowed to evaporate thereby leaving a layer 85 of nanoparticles 23', 25' as shown in Figure 29c (step S14).

Step 14 is repeated so as to assemble multiple layers 85, as shown in Figure 29d.

The material 22' comprising multiple layers 85 of nanoparticles 23', 25' may require annealing so as to form a heterostructure.

A two-step laser annealing process, similar way to that described in JP-A-5-159878, may be used to form heterojunctions between the two types of semiconducting nanoparticles 23', 25' (steps S15 & S16).

As shown in Figure 29e, a laser 86 is used to heat one type of nanoparticle using a beam 87 of light at a first wavelength, and first intensity, I₁. Another laser 88 can be used to heat the other type of nanoparticle using a beam 89 of light at a second, different wavelength, λ₂, and second intensity, I₂ at the same time or at least for an overlapping period of time, t, or subsequently as shown in Figure 29f.

The wavelengths λ₁, λ₂ are chosen according to absorption lines of the two types of nanoparticles 23', 25'. Intensities I₁, I₂ are chosen, for example, based on the volumes of the nanoparticles 23', 25', so as to heat the nanoparticles to appropriate respective temperatures.

Referring to Figure 30, separate, but touching, nanoparticles 23', 25' can be fused by the annealing process, to form heterojunctions 29 and, thus, form a heterostructure comprising nanoparticles 23, 25.

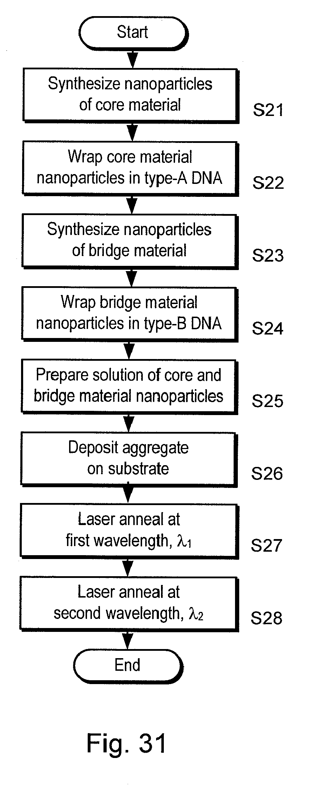

Referring to Figure 31, a second method of fabricating a quantum dot crystal will now be described.

The second method is similar to the first method but differs in that a layers are assembled guided using deoxyribonucleic acid (DNA) as described, for example, in "DNA-guided crystallization of colloidal nanoparticles", Dmytro Nykypanchuk, Mathew M. Maye, Daniel van der Lelie and Oleg Gang, Nature, volume 451, pages 549 to 552 (2008) and "DNA-programmable nanoparticle crystallization", Sung Yong Park, Abigail K. R. Lytton-Jean, Byeongdu Lee, Steven Weigand, George C. Schatz and Chad A. Mirkin, Nature, volume 451, pages 553 to 556 (2008).

Nanoparticles are synthesized as in the first method, but are wrapped in DNA (steps S21 to S24). For example, core nanoparticles can be wrapped in a coat of a first type of DNA ("type A") and bridge nanoparticles can be wrapped in a second type of DNA ("type B").

A solution comprising a mixture of solutions of the two nanoparticles is prepared and a crystal of the nanoparticles is allowed to aggregate (step S25).

The aggregate can be deposited onto a substrate (step S26) and annealed in a similar way to that described earlier.

Other forms of self assembly can be used which may use other forms of linking means, e.g. using chemically or biochemically functionalized nanoparticles, whereby nanoparticles of one type bind to nanoparticles another, different type but not to nanoparticles of the same type as itself.

Quantum dot crystals can be formed using processes commonly used in fabricating semiconductor devices.

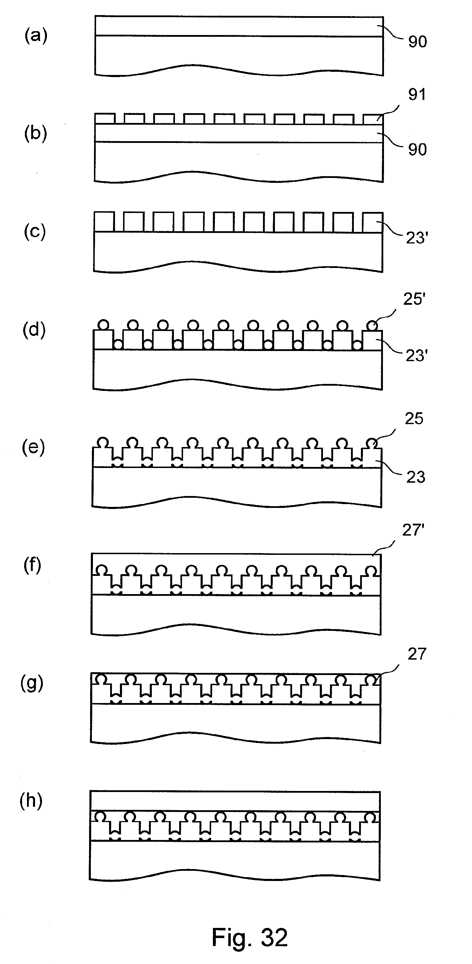

For example, referring to Figures 32a to 32h, depositing a layer 90 of a first type of semiconducting material, e.g. using molecular beam epitaxy, patterning the layer using a lithographically-defined mask 91 and dry etching leaves nanoparticles 23' of a first type as shown in Figure 32c.

Nanoparticles 25' of a second type of can be deposited as particles to a structure as shown in Figure 32d. Alternatively, nanoparticles of the second type can be formed by depositing a further layer of semiconducting material (i.e. overgrowing the layer) and patterning the layer.

The nanoparticles 23', 25' can be annealed using the two-step process described earlier to form a fused structure 23, 25.

A layer of insulating material 27' can be deposited, then etched back to reveal the top of the nanoparticles 25.

The process can be repeated, starting with the deposition of another layer 90 of the first type of semiconducting material.

It will be appreciated that many modifications may be made to the embodiments hereinbefore described. For example, the crystal may be a quasi-crystal.

Other fabrication techniques can be used, such as ion implantation, which can be used in conjunction with layer overgrowth and/or self-assembling nanoparticles.

A quantum dot crystal may be used in a memory device, for example to control charge flowing to and from a memory node, in a control device (such as a transistor) to control charge flow or in an energy storage device, e.g. to control movement of stored charge between cells.

A quantum dot crystal may also be used in quantum information processing, for example, to provide spaced qubits which can be controllably coupled and decoupled.

A quantum dot crystal may be used in electrical, electro-optical and/or optical applications. For example, the material may be used in a device which is optically pumped and which is optically probed or produces an optical response. A region of quantum dot crystal can be used to couple electrical or optical circuits. A device may comprise quantum dot crystal and which is arranged to emit or amplify light or form a modulator. The quantum dot crystal can be used in a similar way to a photonic crystal.

Devices need not be two-terminal, but may include three or more terminals. For example, a device may include a region of a quantum dot material which has two contacts (e.g. ohmic contacts) plus additional contacts, e.g. to modulate or control the behaviour of the material between the contacts. The device may include a region of the material having gate electrode and gate dielectric for producing electrical fields within the material. Contacts and gates can be located on the surface (or surfaces) of the region of the material or be embedded with the material. Contacts and/or gates can be planar or non-planar. Contacts and/or gates may be continuous or broken. Contacts and/or gates can be patterned, e.g. to form a mesh.

Circuits can be formed from a quantum dot crystal in a similar way that circuits are formed in semiconductor materials, such as silicon. The material can be patterned, etched, implanted and provided with contact and/or gating structures. Thus, wires of the quantum dot crystal can be formed, for example, whose properties wary according to its width or "crystal" direction.

A device can be formed from two or more different quantum dot crystals.

## Claims

1. A material comprising an array of nanoparticles comprising a first semiconducting material and nanoparticles comprising a second, different semiconducting material, wherein said nanoparticles form a heterostructure and wherein the nanoparticles have dimensions and the materials yield band offsets such that the material exhibits a localised state which is higher in energy than a delocalised state.

2. A material according to claim 1, wherein the array is two- or three-dimensional.

3. A material according to claim 1 or 2, which is crystal or quasi-crystal.

4. A material according to any preceding claim, wherein the array has cubic symmetry.

5. A material according to any preceding claim, wherein the first semiconducting material has a relatively large band gap and the second semiconducting material has a relatively small band gap.

6. A material according to any preceding claim, wherein said nanoparticles comprising the first semiconducting material are relatively large and said nanoparticles comprising the second semiconducting material are relatively small.

7. A material according to any preceding claim, wherein a linear dimension of said nanoparticles comprising the first semiconducting material is between about 2 and 20 times, optionally between about 5 and 10 times, that of a corresponding linear dimension of said nanoparticles comprising the second semiconducting material.

8. A material according to any preceding claim, wherein the nanoparticles have a linear dimension which is at least 1 nm.

9. A material according to any preceding claim, wherein at least one of the semiconducting materials comprises a II-VI semiconductor.

10. A material according to any preceding claim, wherein at least one of the semiconducting materials comprises a III-V semiconductor.

11. A material according to any preceding claim, wherein at least one of the semiconducting materials comprises a IV semiconductor.

12. A material according to any preceding claim, wherein at least one of the semiconducting materials comprises an organic semiconductor.

13. A material according to any preceding further comprising region(s) between the nanoparticles comprising an insulating material.

14. A device comprising:
a region comprising a material according to any one of claims 1 to 13; and
at least two electrical contacts operatively connected to the region.

15. A device comprising:
a region comprising a material according to any one of claims 1 to 13; and
a source of electromagnetic radiation configured to supply radiation to the region.

16. A photovoltaic cell comprising:
a carrier generation region comprising a material according to any one of claims 1 to 13;
a p-type semiconductor region; and
an n-type semiconductor region.

17. A method of forming a material, the method comprising:
forming an array of nanoparticles comprising a first semiconducting material
and nanoparticles comprising a second, different semiconducting material, wherein said nanoparticles form a heterostructure.

18. A method according to claim 17, wherein forming the array includes: providing a substrate;
providing a colloid of nanoparticles;
allowing said nanoparticles to assemble on said substrate.

19. A method according to claim 17 or 18, comprising:
providing the nanoparticles comprising the first semiconducting material with a first type of linking means; and
providing the nanoparticles comprising the second semiconducting material with second type of linking means which complements the first type of linking means.

20. A method according to claim 19, wherein said first type of linking comprises is a first type of deoxyribonucleic acid and the second type of linking means comprises a second type of deoxyribonucleic acid.

21. A method according to any one of claims 17 to 20, wherein forming the array of nanoparticles includes:
depositing a layer of semiconducting material; and
patterning said layer of semiconducting material.

22. A method according to any one of claims 17 to 21, comprising:
annealing the array of nanoparticles using electromagnetic radiation having a first wavelength.

23. A method according to claim 22, comprising:
annealing the array of nanoparticles using electromagnetic radiation having a second, different wavelength.
